Europäisches Patentamt

European Patent Office

Office européen des brevets

(19)

(11) Veröffentlichungsnummer: **0 257 188**
**A1**

# (12) EUROPÄISCHE PATENTANMELDUNG

(21) Anmeldenummer: 87105785.7

(22) Anmeldetag: 18.04.87

(51) Int. Cl.⁴: **G08B 13/18**

(30) Priorität: 29.07.86 DE 3625643

(43) Veröffentlichungstag der Anmeldung:
02.03.88 Patentblatt 88/09

(84) Benannte Vertragsstaaten:
DE FR GB IT

(71) Anmelder: **Messerschmitt-Bölkow-Blohm**
**Gesellschaft mit beschränkter Haftung**
**Robert-Koch-Strasse**
**D-8012 Ottobrunn(DE)**

(72) Erfinder: **Dietrich, Klaus, Dr.**
**Weinbergstrasse 31**
**D-8726 Gochsheim/ü. Schweinfurt(DE)**

(54) **Ortsauflösender Sensor zur Erfassung einzelner Lichtblitze.**

(57) Beschrieben wird ein ortsauflösender Sensor zur Erfassung einzelner Lichtblitze mit einer Vielzahl von aneinander angrenzenden Lichtempfangselementen, und einer Auswerteschaltung, die das Lichtempfangselement ermittelt, auf dem ein Lichtblitz auftrifft. Erfindungsgemäß weist der Sensor folgende Merkmale auf:

-Die Lichtempfangselemente sind in mehrere Gruppen (I, II, III) derart aufgeteilt, daß jedes Lichtempfangselement ausschließlich an zu anderen Gruppen gehörende Lichtempfangselemente grenzt,
-jeder Gruppe von Lichtempfangselementen ist eine Reihe von Lichtdetektoren (31-34) zugeordnet,
-mindestens ein optisches Verbindungselement (2) stellt zwischen jedem einzelnen Lichtempfangselement und Lichtdetektoren (31-34) die entsprechend einem bestimmten Code aus der zugeordneten Reihe von Lichtdetektoren ausgewählt sind, eine lichtleitende Verbindung her.

Durch diese Merkmale kann mit wenigen Lichtdetektoren eine hohe Raumwinkelauflösung erreicht werden. Darüberhinaus erfolgt die Ausgabe der Ordnungsnummer des Lichtempfangselement, das einen Lichtblitz registriert hat, direkt in einem digitalen Code.

FIG. 1

FIG. 2

## Ortsauflösender Sensor zur Erfassung einzelner Lichtblitze

Die Erfindung bezieht sich auf einen ortsauflösenden Sensor zur Erfassung einzelner Lichtblitze gemäß dem Oberbegriff des Patentanspruchs 1.

Derartige Sensoren werden beispielsweise als Laserwarnsensoren mit hoher Winklauflösung verwendet.

Bei den bekannten Laserwarnsensoren hoher Winkelauflösung wird der zu überwachende Raumwinkel in eine Vielzahl einzelner Raumwinkel-Segmente aufgeteilt und von einem Laserwarnsensor mit einer "Facetten-Struktur" beobachtet. Zur Bestimmung des Raumwinkels, aus dem ein Laserstrahl kommt, wird entweder jedem Raumwinkel-Segment ein eigener Strahlungsdetektor zugeordnet, oder die auf einzelnen Facetten einfallende Strahlung wird beispielsweise mit Hilfe von für jede Facette unterschiedlich langen Glasfasern auf einen einzigen Detektor geführt. Die erste Lösung hat insbesondere bei hoher Winkelauflösung, bei der viele Detektoren erforderlich sind, den Nachteil hoher Kosten. Bei der zweiten Lösung wird ein hochauflösendes Zeitmeßgerät benötigt, zusätlich muß ein aus dem gesamten beobachteten Raumwinkel gewonnenes Signal bereitgestellt werden. Damit hat auch diese Lösung den Nachteil, daß ein großer Aufwand erforderlich ist.

Der Erfindung liegt die Aufgabe zugrunde, einen beispielsweise als Laserwarnsensor verwendbaren ortsauflösenden Sensor anzugeben, der eine große Winkelauflösung bei geringem gerätetechnischen Aufwand und damit kleinen Kosten erlaubt.

Eine erfindungsgemäße Lösung dieser Aufgabe ist mit ihren Weiterbildungen in den Patentansprüchen gekennzeichnet.

Erfindungsgemäß wird ein ortsauflösender Sensor zur Erfassung einzelner Lichtblitze gemäß dem Oberbegriff des Patentanspruchs 1 derart weitergebildet, daß die einzelnen Lichtempfangselemente in mehrere Gruppen derart aufgeteilt sind, daß jedes Lichtempfangselement ausschließlich an zu anderen Gruppen gehörende Lichtempfangselemente grenzt. Dabei überwacht in bekannter Weise jedes Lichtempfangselement ein bestimmtes Raumwinkel-Segment, die lückenlos aneinander grenzen und je nach Aufgabenstellung einen bestimmten Raumwinkelbereich oder den gesamten Raumwinkel beobachten. Jeder Gruppe von Lichtempfangselementen ist eine Reihe von Lichtdetektoren zugeordnet, die durch optische Verbindungselemente entsprechend einem bestimmten Code mit den entsprechenden Lichtempfangselementen vebunden sind.

Die Zahl der einer Gruppe von Lichtempfangselementen zugeordneten Lichtdetektoren ist durch die Zahl der Lichtempfangselemente in dieser Gruppe sowie den gewünschten Code bestimmt. Soll die Ordnungsnummer des Lichtempfangselements, das einen Lichblitz registriert hat, beispielsweise im Binärcode (Anspruch 9) ausgegeben werden, so benötigt man bei z.B. 1024 Lichtempfangselementen pro Gruppe lediglich 10 Detektoren, deren Ausgangssignal als 10-Bit-Wort die Ordnungsnummer des beleuchteten Lichtempfangselements angibt. Nach dem Stand der Technik, bei dem jedem Lichtempfangselement ein Lichtdetektor zugeordnet ist, wären dagegen 1024 Detektoren und entsprechende nachgeordnete Auswerteschaltungen erforderlich.

Trotzdem ist durch die erfindungsgemäße Aufteilung der Lichtempfangselemente in mehrere Gruppen sichergestellt, daß der Code, durch den die Ordnungsnummer der beleuchteten Lichtempfangselemente ausgegeben wird, nicht dadurch verfälscht wird, daß ein Lichtblitz gleichzeitig auf zwei Lichtempfangselemente auftrifft. Da immer zu unterschiedlichen Gruppen gehörende Lichtempfangselemente aneinander grenzen, erzeugt ein gleichzeitig auf zwei Lichtempfangselemente auftreffender Lichtblitz Ausgangssignale in zu unterschiedlichen Gruppen gehörenden Lichtdetektoren, wobei in jeder Gruppe aber die zutreffende Ordnungsnummer in dem gewünschten Code ausgegeben wird. Beispielsweise kann der erfindungsgemäße ortsauflösende Sensor einen mit an sich bekannten elektronischen Mitteln aufgebauten Ereignisselektor aufweisen (Anspruch 11), der den Raumwinkel des Lichtblitzes bestimmt, wenn gleichzeitig benachbarte Lichtempfangselemente, die unterschiedlichen Gruppen angehören, beleuchtet werden.

Weiterbildungen der Erfindung sind in den Unteransprüchen angegeben.

Je nach Anwendungsfall können die Lichtempfangselemente als Zeile oder als Array angeordnet sein. Bei einer zeilenförmigen Anordnung sind mindestens zwei, bei einer arrayförmigen Anordnung mindestens drei Gruppen erfordelich, damit sichergestellt ist, daß nicht zu gleichen Gruppen gehörende Lichtempfangselemente aneinander grenzen (Anspruch 2 bzw. 3).

Das optische Verbindungselement, das entsprechend dem gewünschten Code eine lichtleitende Verbindung zwischen jedem einzelnen Lichtempfangselement und den zugeordneten Lichtdetektoren herstellt, kann im Prinzip in beliebiger Weise aufgebaut sein, beispielsweise kann es Bündel von Lichtleitfasern enthalten.

Besonders einfache Realisierungen des optischen Verbindungselements sind in den Ansprüchen 4 und 5 gekennzeichnet.

Gemäß Anspruch 4 weist das optische Verbindungselement eine Mikroprismenplatte auf, die ein ortsabhängiges Prismenmuster enthält, das das auf jedes Lichtempfangselement auftreffende Licht in soviele Einzelstrahlen aufteilt, wie nach dem gewählten Code für die Darstellung der Ordnungsnummer dieses Lichtempfangselements erforderlich ist, und die Einzelstrahlen an die entsprechenden Lichtdetektoren anlegt.

Bei der im Anspruch 5 gekennzeichneten Weiterbildung sind lichtleitenden Elemente vorgesehen.

Durch die im Anspruch 6 gekennzeichnete Weiterbildung ergibt sich eine weitere Vereinfachung des Aufbaus. Beispielsweise bei Verwendung einer Mikroprismenplatte ist es möglich, die Mikroprismenelemente, die Licht auf Detektoren lenken, die bei der Darstellung der Ordnungsnummer immer das Signal "Null" abgeben, zu schwärzen, so daß bei Auftreffen eines Lichtblitzes kein Licht auf diese Detektoren auftreffen kann.

Im Anspruch 7 ist eine Weiterbildung angegeben, die in einfacher Weise die Realisierung der Richtungsselektivität erlaubt. Bei der in Anspruch 8 gekennzeichneten Ausgestaltung besteht das richtungsselektive Element bzw. das Facettenauge aus einem lichtundurchlässigen Material, in dem für jedes Lichtempfangselement ein Durchgangskanal vorgesehen ist, dessen Lage und Richtung nur das Auffallen von Licht aus dem entsprechenden Raumwinkel-Segment erlaubt.

Die Erfindung wird nachstehend anhand von Ausführungsbeispielen unter Bezugnahme auf die Zeichnung näher beschrieben, in der zeigen:

Fig. 1 schematisch einen erfindungsgemäßen Sensor im Schnitt,

Fig. 2 ein Beispiel für eine Anordnung der Gruppen von Lichtempfangselementen,

Fig. 3 ein Beispiel für eine zeilenförmige Anordnung der Lichtempfangselemente, und

Fig. 4 ein Beispiel für eine arrayförmige Anordnung der Lichtempfangselemente.

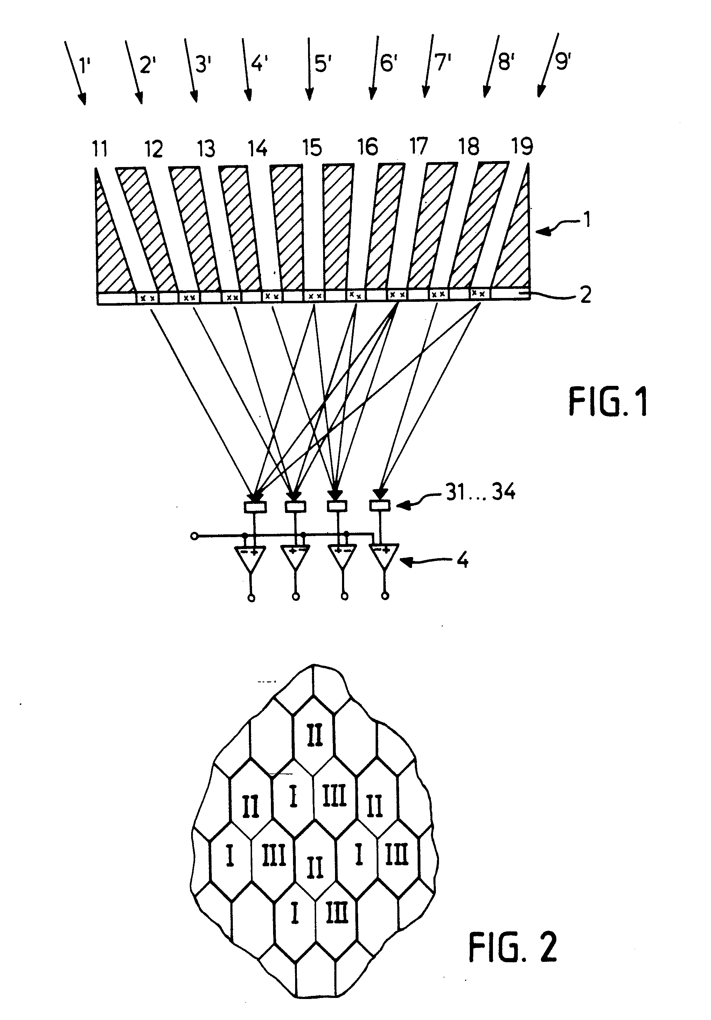

Fig. 1 zeigt schematisch einen erfindungsgemäßen ortsauflösenden Sensor im Schnitt. Zur Vereinfachung der Darstellung sind lediglich die zu einer Gruppe gehörenden Lichtempfangselemente dargestellt. Der Sensor weist ein richtungsselektives Element 1 auf, das eine Reihe von Licht-Durchgangskanälen 11 bis 19 enthält. Die Neigung der Licht-Durchgangskanäle 11 ... 19 ist derart gewählt, daß durch jeden Licht-Durchgangskanal nur aus einem bestimmten Raumwinkel-Segment kommende Lichtstrahlen 1' ... 9' hindurchtreten können. Am lichtaustrittsseitigen Ende der Licht-Durchgangskanäle 11 ... 19 ist eine Mikroprismenplatte 2 angeordnet, die ein ortsabhängiges Prismenmuster aufweist und das Licht auf Detektoren 31 ... 34 lenkt. Das ortsabhängige Prismenmuster ist so ausgebildet, daß das Licht, das durch einen bestimmten Licht-Durchgangskanal hindurchtritt, nur den Detektoren zugeführt wird, die zur Codierung des Raumwinkel-Segments ein Signal erhalten müssen.

Den Detektoren 31 ... 34 ist eine Auswerteschaltung 4 nachgeschaltet, die Fig. 1 nur schematisch dargestellt ist und die die Ordnungsnummer des Lichtempfangselements, auf das ein Lichtblitz aufgetroffen ist, in codierter Form, beispielsweise im Binärcode ausgibt. Der Aufbau der Auswerteschaltung kann in beliebiger Form erfolgen, so daß auf eine Beschreibung verzichtet werden kann.

Wie bereits ausgeführt, zeigt Fig. 1 nur einen schematischen Querschnitt durch einen erfindungsgemäßen Sensor, bei dem zur Vereinfachung der Darstellung nur die Licht-Durchtrittskanäle und die Detektoren dargestellt sind, die zu einer Gruppe gehören.

Fig. 2 zeigt eine mögliche Anordnung von zu drei Gruppen I ... III gehörenden Lichtempfangselementen. Wie Fig. 2 zu entnehmen ist, grenzen ausschließlich zu anderen Gruppen gehörende Lichtempfangselemente an ein bestimmtes Lichtempfangselement. Damit ist es ausgeschlossen, daß ein auf die Grenze zwischen zwei Lichtempfangselementen auftreffender Lichtstrahl zu einer Zerstörung des Codes führt.

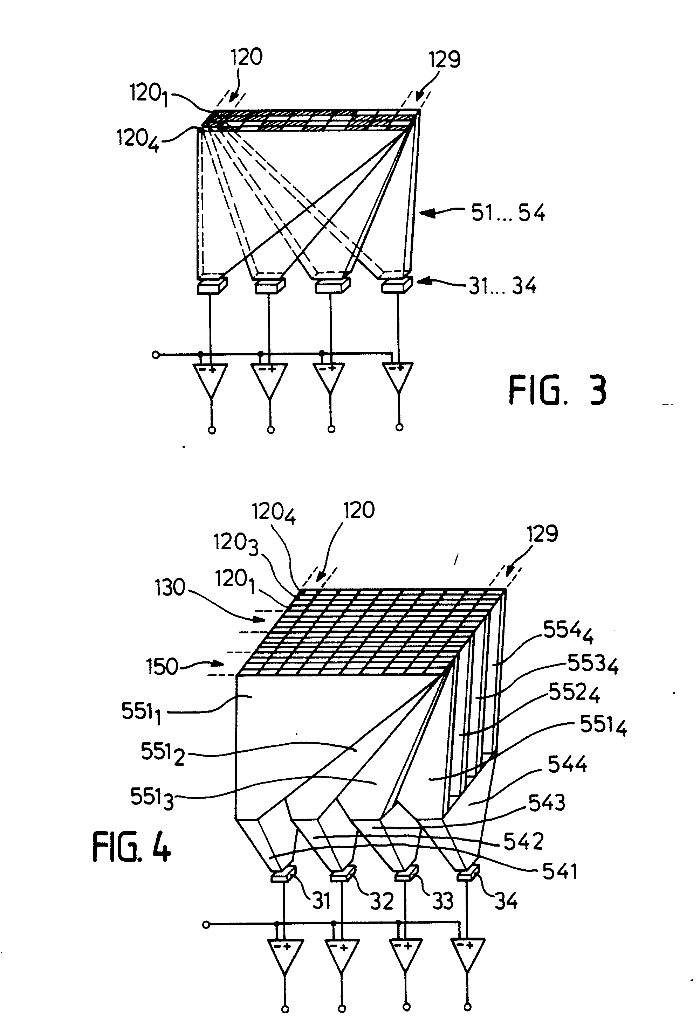

In den Figuren 3 und 4 sind weitere Ausführungsformen für das lichtleitende Verbindungselement angegeben. Aus Gründen der Übersichtlichkeit sind lediglich die Lichtempfangselemente einer Gruppe dargestellt; bei der erfindungsgemäß realisierten in mindesten zwei bzw. drei Gruppen sind die Ausführungsformen entsprechend zu modifizieren.

Fig. 3 zeigt ein Beispiel für eine zeilenförmige Anordnung der Lichtempfangselemente. Zehn Lichtempfangselemente 120 bis 129 sind nebeneinander angeordnet. Jedes Lichtempfangselement besteht aus vier Teilflächen $120_1$ ... $120_4$ ... $129_4$. Jeweils die Flächen $x_1$ sind über Lichtleitscheiben 51 ... 54 mit Detektoren 31 ... 34 verbunden. Ensprechend dem gewünschten Code, in diesem Falle einem Binärcode, sind in jedem Lichtempfangselement ein Teil der Flächen derart geschwärzt, daß als Ausgangssignal der Detektoren die binärverschlüsselte Ordnungsnummer 1 ... 10 der Lichtempfangselemente entsteht.

Fig. 4 zeigt ein Ausführungsbeispiel, bei dem Lichtempfangselemente 120...129, 130...150 arrayförmig angeordnet sind. Jedes Lichtempfangselement besteht aus mehreren Flächen $x_1$, die über Lichtleitscheiben $551_1$, $551_2$, ... $551_4$, $552_i$, $553_i$ bzw. $554_i$ (i = 1...4) mit Detektoren 31 ... 34 verbunden.

Die Auswahl eines bestimmten Codes, beispielsweise eines Binärcodes erfolgt wiederum durch Schwärzen einzelner Teilflächen $x_i$ der Lichtempfangselemente. Ausdrücklich wird darauf hingewiesen, daß zur vereinfachten zeichnerischen Darstellung in Fig. 4 nur ein Teil der Lichtleitscheiben bzw. Detektoren dargestellt ist, die zur binären Verschlüsselung der Ordnungsnummer der einzelnen Lichtempfangselemente benötigt werden.

Ansonsten entspricht der Aufbau und die Funktionsweise des in Fig. 4 dargestellten Ausführungsbeispiels dem in den Figuren 1 bis 3 erläuterten Beispielen.

Vorstehend ist die Erfindung anhand von Ausführungsbei spielen ohne Beschränkung des allgemeinen Erindungsgedankens, die Lichtempfangselemente in mehrere Gruppen aufzuteilen, wobei nur zu unterschiedlichen Gruppen gehörende Lichtempfangselemente aneinander grenzen, beschrieben worden.

Innerhalb dieses allgemeinen Erfindungsgedankens sind selbstverständlich die verschiedensten Modifikationen möglich:

Beispielsweise können die Lichtempfangselemente in mehr Gruppen als unbedingt für die Erfüllung der Bedingung "kein Lichtempfangselement grenzt an ein Element der gleichen Gruppe" notwendig aufgeteilt sein.

Die Lichtempfangselemente können selbstverständlich beliebig aufgebaut und der Wellenlänge der einfallenden Strahlung angepaßt sein.

Auch das optische Verbindungselement kann einen beliebigen Aufbau haben: die erfindungsgemäß vorgesehene "codierte optische Verbindung" kann beispielsweise durch geeignete Auswahl oder Kombination von Lichtbeugung, Lichtbrechung, Lichtabsorption, Lichtpolarisation und/oder Lichtstreuung verwendeten Elementen erzielt werden.

Auch ist die Verwendung des erfindungsgemäßen ortsauflösenden Sensores selbstverständlich nicht auf Laserwarn-Sensoren beschränkt. Vielmehr eignet sich der erfindungsgemäße Sensor für den Nachweis beliebiger Lichtblitze, solange sich nicht zwei aus unterschiedlichen Raumwinkeln kommende Lichtblitze zeitlich überlappen. Durch eine entsprechende Aufteilung in "Makro-Gruppen" und zusätz liche Logikschaltung ist jedoch auch in solchen Fällen gegebenenfalls ein Nachweis möglich.

**Ansprüche**

1. Ortsauflösender Sensor zur Erfassung einzelner Lichtblitze mit einer Vielzahl von aneinander angrenzenden Lichtempfangselementen, und einer Auswerteschaltung, die das Lichtempfangselement ermittelt, auf dem ein Lichtblitz auftrifft, **gekennzeichnet** durch folgende Merkmale:
-die Lichtempfangselemente sind in mehrere Gruppen (I,II,III)derart aufgeteilt, daß jedes Lichtempfangselement ausschließlich an zu anderen Gruppen gehörende Lichtempfangselemente grenzt,
-jeder Gruppe von Lichtempfangselementen ist eine Reihe von Lichtdetektoren (31...34) zugeordnet,
-mindestens ein optisches Verbindungselement (2; 51...54; 541...544, 551...554) stellt zwischen jedem einzelnen Lichtempfangselement (120...150) und Lichtdetektoren (31...34), die entsprechend einem bestimmten Code aus der zugeordneten Reihe von Lichtdetektoren ausgewählt sind, eine lichtleitende Verbindung her.

2. Sensor nach Anspruch 1,
dadurch **gekennzeicht**, daß die Lichtempfangselemente (120...124) eine Zeile bilden und in mindestens zwei Gruppen aufgeteilt sind.

3. Sensor nach Anspruch 1,
dadurch **gekennzeichnet**, daß die Lichtempfangselemente (120...129,130...150) ein Array bilden und in mindestens drei Gruppen (I,II,III) aufgeteilt sind.

4. Sensor nach einem der Ansprüche 1 bis 3,
dadurch **gekennzeichnet**, daß das optische Verbindungselement eine Mikroprismenplatte (2) aufweist.

5. Sensor nach einem der Ansprüche 1 bis 3,
dadurch **gekennzeichnet**, daß das optische Verbindungselement eine Mehrzahl von lichtleitenden Elementen (51...54; 541...542, 551....554) aufweist.

6. Sensor nach Anspruch 4 oder 5,
dadurch **gekennzeichnet** , daß die Lichtempfangselemente lichtabsorbierende Bereiche aufweisen, die entsprechend dem gewählten Code verteilt sind.

7. Lichtempfangselement nach einem der Ansprüche 1-6,
dadurch **gekennnzeichnet**, daß zur Bestimmung der Richtung, aus der ein registrierter Lichtblitz kommt, in Lichtrichtung vor dem Lichtempfangselement ein richtungsselektives Element bzw. ein Facettenauge (1) angeordnet ist.

8. Sensor nach Anspruch 7,
dadurch **gekennzeichnet** , daß das richtungsselektive Element (1) aus einem lichtundurchlässigen Material besteht, in dem für jedes Lichtempfangselement ein Durchgangskanal (11...19) entsprechend dem zugeordneten Raumwinkelsegment vorgesehen ist.

9. Sensor nach einem der Ansprüche 1 bis 8,
dadurch **gekennzeichnet**, daß der Code ein Binärcode ist.

10. Sensor nach einem der Ansprüche 1 bis 8, dadurch **gekennzeichnet**, daß der Code ein Gray-Code ist.

11. Sensor nach einem der Ansprüche 1 bis 10, dadurch **gekennzeichnet**, daß die Auswerteschaltung einen Ereignisselektor aufweist, der den Raumwinkel des Lichtblitzes bestimmt, wenn gleichzeitig benachbarte Lichtempfangselemente, die unterschiedlichen Gruppen angehören, beleuchtet werden.

12. Sensor nach einem der Ansprüche 1 bis 11, **gekennzeichnet** durch die Verwendung als Laserwarnsensor.

FIG.1

FIG. 2

9926

FIG. 3

FIG. 4

9926

## EINSCHLÄGIGE DOKUMENTE

EP 87105785.7

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE - A1 - 2 425 466 (ERNST LEITZ GMBH)<br><br>* Gesamt; insbesondere Fig.6; Seite 5, 2. Absatz *<br><br>-- | 1 | G 08 B 13/18 |
| A | DE - B2 - 2 653 111 (CERBERUS AG)<br><br>* Gesamt; insbesondere Spalte 4, Zeilen 58-65; Fig. 2 *<br><br>-- | 1 | |
| A | DE - B2 - 2 537 380 (SECURITY ORGANIZATION SUPREME, INC.)<br><br>* Fig. 4; Spalte 8, Zeilen 18-34 *<br><br>-- | 1 | |
| A | DE - A - 2 260 486 (BARNES ENGINEERING CO.)<br><br>-- | | RECHERCHIERTE SACHGEBIETE (Int. Cl.4) |
| A | US - A - 4 529 874 (ZIERHUT)<br><br>-- | | G 08 B 13/18<br>G 08 C 23/00 |
| A | WO - A1 - 83/03 697 (PIETSCHMANN)<br><br>---- | | |

Der vorliegende Recherchenbericht wurde für alle Patentansprüche erstellt.

| Recherchenort | Abschlußdatum der Recherche | Prüfer |
|---|---|---|
| WIEN | 17-11-1987 | HÜTTNER |